# EUROPEAN PATENT SPECIFICATION

(11) **EP 2 856 564 B1**
(45) Date of publication and mention of the grant of the patent: **31.01.2018**
(21) Application number: 13798145.2
(22) Date of filing: 05.03.2013
(51) Int. Cl.: H01R 12/79, H05K 3/36, H01R 13/52, H01R 13/193

(54) **APPARATUS FOR ELECTRICALLY CONNECTING A FLEXIBLE CIRCUIT TO A RECEIVER**
VORRICHTUNG ZUR ELEKTRISCHEN VERBINDUNG EINER FLEXIBLEN SCHALTUNG AN EINEN EMPFÄNGER
APPAREIL POUR LA CONNEXION ÉLECTRIQUE D'UN CIRCUIT FLEXIBLE À UN RÉCEPTEUR

(30) Priority: 31.05.2012 US 201261653813 P; 06.02.2013 US 201313760574
(43) Date of publication of application: 08.04.2015
(73) Proprietor: HiRel Connectors, Inc., Claremont, CA 91711 (US)
(72) Inventor: RITNER, William, Claremont, California 91711 (US)
(74) Representative: Carmody, Mark
(86) International application number: PCT/US2013/029155
(87) International publication number: WO 2013/180775

(56) References cited:
- EP-A1- 1 571 733
- US-A- 4 526 432
- US-A- 4 526 432
- US-A- 5 158 479
- US-A1- 2007 167 089
- US-A1- 2009 149 036
- US-B1- 6 409 531
- "Gold Dot (TM) Connection Systems Connection Systems", , 31 March 2003 (2003-03-31), XP055231264, Retrieved from the Internet: URL:http://www.koehlke.com/pdf/Delphi/Delp hi_Gold_Dot_Connections_overview.pdf [retrieved on 2015-11-25]

## Description

### FIELD OF THE INVENTION

The invention relates generally to electrical connection assemblies and, more particularly, to electrical connection assemblies comprising a flexible electrical conductor and a rigid assembly, such as a circuit board.

### BACKGROUND OF THE INVENTION

Sophisticated electrical and electronic components are frequently disposed proximate to high vibration equipment, such as aircraft and rocket engines. Because of the narrow confines wherein such components are typically disposed, interconnecting such components often employs the use of flexible electrical conductors ("flexible assemblies").

The prior art methods of attaching a flexible assembly to a rigid assembly (such as a circuit board) usually employ some form of permanent attachment, such as methods wherein the flexible assembly is soldered to the rigid assembly.

Problems arise in such prior art methods when the attachment between the flexible assembly and the rigid assembly needs to be disengaged (to repair the rigid assembly, or for other relevant purposes requiring disassembly or unmating of the assembly). Such activities cannot easily (if at all) be performed in the field, and, in most cases, require the complete replacement of both flexible assembly and rigid assembly. Such complete replacement of both assemblies is awkward, time-consuming and expensive.

United States Patent No. 4,526,432 to Cronin et al ("Cronin") discloses a connector cap that screws on to a receiver. Such a cap receiver relationship is subject to loosening and unintentional disengagement in extreme operational environments. Cronin teaches that the flexible assembly is mechanically coupled to the receiver, which is part of the rigid body assembly thus making it cumbersome to effect quick change in the field. For instance, to move the flexible assembly from one device with a receiver to another with a receiver requires mechanically uncoupling the connector cap from the receiver and also mechanically uncoupling the flexible terminal from the receiver, which could be time consuming.

Products marketed under the Gold-Dot™ trademark by Delphi Connection Systems of Irvine, California disclose pin-socket mating systems, spring probe systems and compressive contact systems for use in connectors for different type applications.

European Patent No. 1571733 to Cinch Connectors discloses a connector that is coupled to a receiver with screws thus making it unusable for tight environments such as is encountered in aerospace type applications.

Accordingly, there is a need for a method of attaching a flexible assembly to a rigid assembly which does not involve the aforementioned problems in the prior art.

### SUMMARY OF THE INVENTION

The invention satisfies this need. The invention is an electrical assembly combination according to claim 1 comprising (a) a receiver having a receiver housing and a plurality of receiver housing electrical contacts, and (b) a connector device comprising a connector housing capable of accepting and retaining a terminal end of a flexible assembly having a plurality of flexible assembly electrical contacts. In the invention, the connector device is capable of being reversibly attached to the receiver housing such that each of the receiver housing electrical contacts is electrically connected to a flexible assembly electrical contact in a removable, non-permanent manner.

An objective of this invention disclosure is to define an apparatus comprising a mechanical device and specifically designed receiver for electrically and mechanically connecting a rigid, semi-rigid and/or flexible circuit assembly (hereby referred to as "flexible circuit") and a plurality of replaceable and repairable conductive elements found within the flexible circuit directly to a specifically designed receiver termination point comprising a plurality of conductive elements located within the receiver in a manner that: a) the mechanical device contains the flexible circuit and flexible circuit elements and the receiver contains the receiver conductive elements and; b) the mechanical device may be non-destructively disconnected from the specialized receiver and; c) some or all of the conductive elements may be replaceable and/or repairable within the apparatus and; d) the flexible circuit conductive elements may be non-destructively engaged and/or disengaged with the receiver conductive elements and; e) physically isolates the connected end of the flexible circuit and mating interface of the receiver termination point from both foreign contaminates and stray electrical transients and; f) maintains both electrical connectivity and contaminant protection when subject to extreme environments including, but not limited to, mechanical, thermal, electrical, and chemical stresses.

A feature of preferred embodiments of this combination includes an enclosure for accepting and retaining the flexible circuit mating end such that the flexible circuit may be non-destructively removed from the enclosure, and positions the flexible circuit within the enclosure in a manner that allows the electrically conductive elements found within the flexible circuit to be exposed to the conductive elements found within the receiver in order to make physical contact and become electrically interconnected with the flexible circuit conductive elements in a non-permanent form that would allow the flexible circuit conductive elements to become disengaged from the receiver conductive elements without causing damage to either the flexible circuit conductive elements or the receiver conductive elements.

In this regard, the combination includes a plurality of conductive elements found within both the flexible circuit and receiver, wherein the flexible circuit conductive elements and receiver conductive elements may physically join in a manner that creates an electrical connection between the two mated elements, and the mated elements may be disconnected from each other without causing damages to either of the conductive elements, and the conductive elements may be removed from their retention feature within their respective housing without causing damages to either the conductive element or retention feature or housing, and may be configured using existing solderless connection methods, including but not limited to: pin-socket mating systems, spring probe systems and compressive contact systems, such as those marketed under the Gold-Dot™ trademark by Delphi Connection Systems of Irvine, California.

An additional feature that may be included in the combination is a physical seal or barrier between both the enclosure for the flexible circuit and the receiver acting in a manner that prevents any undesirable foreign entities, including both physical contaminants and stray electrical transients, from entering the engagement area between the flexible circuit conductive elements and the receiver conductive elements. The designer of the apparatus may include additional sealing points of the apparatus, given the specific design intent of the apparatus.

Another feature that is included in the combination is an interlocking mechanism between both the flexible circuit enclosure device and the receiver that upon full engagement of the interlocking mechanism: a) the flexible circuit conductive elements are electronically connected with the receiver conductive elements and; b) the seal between the enclosure and receiver is active in preventing foreign contamination, including both physical contaminants and stray electrical transients. The interlocking mechanism provides assurance that the enclosure and receiver do not become disengaged during operation of the apparatus in environments that would otherwise cause disengagement without the use of an interlocking mechanism, thereby making the apparatus useful in extreme environments in that the apparatus will continue to serve its other primary functions of sealing and engaging the conductive elements found within the flexible circuit and receiver.

The combination may further incorporate active and passive accessories and components, such as signal filters, signal indicators and power regulators. The apparatus may further incorporate design features, such as "scoop-proof" components or keying features to ensure proper alignment of conductive elements.

Thus, the invention provides a combination for electronically connecting a flexible circuit to a termination point, consisting of a device and receiver. The apparatus comprises an enclosure for the flexible circuit wherein the flexible circuit may be non-destructively removed from the enclosure. The flexible circuit is contained such that the conductive elements found in the flexible circuit are exposed. The conductive elements are non-permanently electrically connected to conductive elements found in the flexible circuit. The conductive elements consist of electrically conductive materials physically configured to engaged and disengage in a nondestructive manner by conventional or nonconventional means.

The combination can further comprise seals between the device and receivers to prevent contamination from foreign entities, including both physical contaminants and stray electrical transients. The seals typically comprise sealing components found in the device, the receiver, or both.

The combination further comprises an interlocking mechanism that is suitable for engaging the device to the receiver. The interlocking mechanism typically comprises features that ensure engagement between the conductive elements in the flexible circuit and the conductive elements found in the receiver. Such interlocking mechanism preferably comprises a feature that ensures activation of the seals. The interlocking mechanism typically further comprises features that maintain the functionality of the interlocking mechanism and conductive element engagement in situations that would otherwise compromise the functionality of the apparatus.
The invention is set out in the appended claims.

### DRAWINGS

These and other features, aspects and advantages of the present invention will become better understood with reference to the following description, appended claims and accompanying drawings where:
Figure 1 is a perspective view of an electrical assembly combination having features of the invention;
Figure 2 is an exploded perspective view of a receiver and connector device comprising the electrical assembly combination illustrated in Figure 1;
Figure 3 is a fully exploded perspective view of the electrical assembly combination having features of the invention; and
Figure 4 is a cross-sectional view of the fully-assembled electrical assembly combination illustrated in Figure 1.

### DETAILED DESCRIPTION OF THE INVENTION

The following discussion describes in detail one embodiment of the invention and several variations of that embodiment.

The invention is an electrical assembly combination 10 useful in connecting a flexible assembly 22 to a rigid assembly 12. The invention comprises a receiver 13 and a connector device 14.

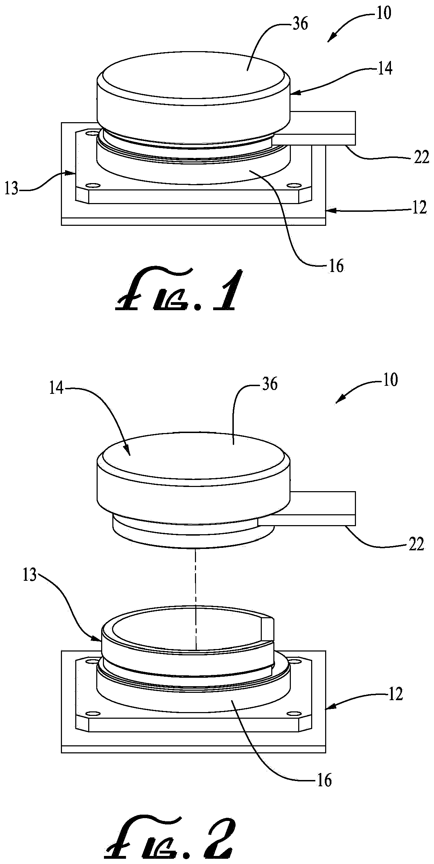

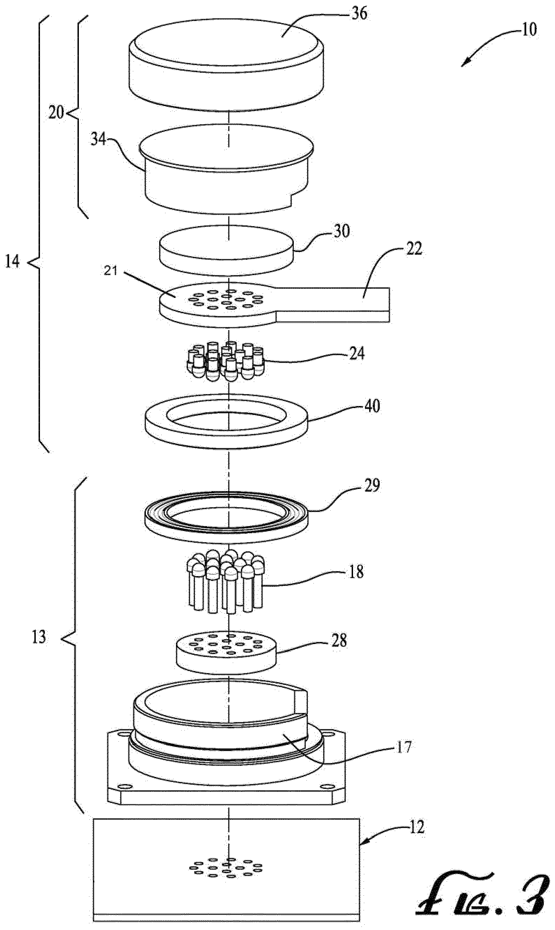

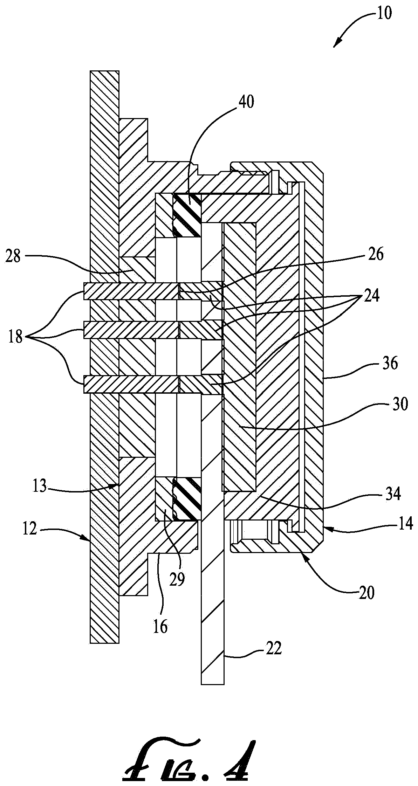

One embodiment of the electrical assembly combination 10 is illustrated in Figure 1. Figure 2 illustrates the receiver and connector device individually. Figure 3 is a fully exploded view of the electrical assembly combination, and Figure 4 is a cross-sectional view of the electrical assembly combination, showing how the principal component parts are assembled.

The receiver 13 comprises a receiver housing 16 and a plurality of receiver housing electrical contacts 18.

The connector device 14 comprises a connector housing 20 for retaining a flexible assembly 22. The flexible assembly 22 includes a plurality of flexible assembly electrical contacts 24.

The connector housing 20 is capable of accepting and retaining a terminal end 21 of a flexible assembly 22 having the plurality of flexible assembly electrical contacts 24.

The connector device 14 is reversibly attached to the receiver housing 16, such that each of the receiver housing electrical contacts 18 is electrically connected to a flexible assembly electrical contact 24 in a removable, non-permanent manner. Thus, all contacts 18 and 24 may be both serviceable and solderless. Each receiver housing electrical contact 18 is mated to an assembly electrical contact 24 by one of several solderless connection methods known in the art, including, but not limited to, pin-socket mating systems; spring probe systems and compressive contact systems, such as those marketed under the Gold-Dot™ trademark by Delphi Connection Systems of Irvine, California. In the embodiment illustrated in Figure 4, each receiver housing contact 18 is mated to an assembly electrical contact 24 at a conductive element engagement surface 26.

In the embodiments illustrated in the drawings, the rigid assembly 12 is a circuit board, although the invention can also be used with other types of rigid assemblies. The receiver 13 further comprises an insulator assembly 28 which can be constructed of glass-filled epoxy resin or similar material. The insulator assembly is used to mechanically retain, electronically isolate and insulate the receiver housing electrical contacts 18. Thus, insulator assembly 28 holds and electrically insulates each one of the plurality of receiver housing electrical contacts 18 from each other.

In the embodiment illustrated in the drawings, the receiver 13 further comprises a sealing component 29 for sealing the receiver housing 16 to the connector device 14.

The connector housing 20 is used as a structural member and as support for the flexible assembly 22, as well as for vibration dampening purposes. The connector housing 20 can be made from a multitude of materials, including but not limited to the following: aluminum, titanium, steel, plastic, PEEK, as well as composites (conductive or non-conductive). The cross-sectional shape of the connector housing 20 can be circular, rectangular, as well as other shapes. The connector housing 20 can have multiple entry locations for a plurality of flexible assemblies 22. The connector housing 20 comprises a device enclosure 34 and an interlock mechanism cap 36. The device enclosure 34 and the interlock mechanism cap 36 serve the purpose of enclosing and sealing the flexible assembly 22 and provide environmental/EMI, EMC protection. The interlock mechanism cap 36 can be made from a variety of materials such as, but not limited to, aluminum, titanium, steel and composites (conductive and non-conductive). The device enclosure 34 and the interlock mechanism cap 36 can be assembled to one another with various mechanical retention elements such as, but not limited to, bolts, threaded studs and captive screws.

As noted above, the device anclosure 34 retains the terminal end 21 of the flexible assembly 22, such that the flexible assembly 22 may be non-destructively removed from the enclosure 34. The device enclosure 34 positions the flexible assembly 22 within the connector housing 20 in a manner that allows the flexible assembly electrical contacts 24 to be exposed to the receiver housing electrical contacts 18 in order to make physical contact and become electrically interconnected with the receiver housing contacts 18 in a non-permanent form. Such non-permanent interconnection allows the flexible assembly electrical contacts 24 to become disengaged from the receiver housing electrical contacts 18 without causing damage to either the flexible assembly electrical contacts 24 or to the receiver housing electrical contacts 18. The connector device 14 further comprises a compression grommet 30 constructed of silicon or similar material. The compression grommet 30 is used to support the flexible assembly 22 inside of the connector device 14 and to dampen movement when the connector device 14 is subject to vibration. The connector device 14 further comprises a flexible assembly retention component 40 which securely retains the flexible assembly 22 within the connector device 14.

The connector device 14 can further comprise active and passive accessories and components, such as signal filters, signal indicators and power regulators. The connector device 14 may further incorporate design features, such as "scoop-proof" components or keying features to ensure proper alignment of conductive elements 18 and 24.

The flexible assembly 22 can comprise an optional sealing grommet (not shown) to seal the flexible assembly within the connector housing. Such sealing grommet provides a sealing interface between the flexible assembly 22 and the connector housing 20.

The optional sealing component 29 provides a seal to protect the space between the various components of the electrical assembly combination to prevent contamination from foreign entities. Such seal acts in a manner that prevents any undesirable foreign entities from entering the engagement area between the flexible assembly electrical contacts and the receiver housing electrical contacts. The use of grommets and/or gaskets can also be incorporated into the combination to serve an array of functions, such as, but not limited to, environmental sealing, EMI/EMC bonding, vibration dampening and air volume reduction.

The electrical assembly combination 10 facilitates the installation and replacement of a flexible assembly 22 to a rigid assembly 12 without the use of solder or other permanent connection. Furthermore, the electrical assembly combination of the invention 10 provides assurance that the flexible assembly 22 and the rigid assembly 12 do not become disengaged during operation of the combination in environments that would otherwise cause disengagement, thereby making the electrical assembly combination useful in extreme environments. The several sets of mated electrical contacts 18 and 24 may be individually disconnected from each other at a conductive element engagement surface 26 without causing damages to any of the contacts 18 and 24, and any contact 18 and 24 may be removed from its respective retention structure without causing damages to the contact 18 and 24 or to the retention structure.

## Claims

1. An electrical assembly combination (10) comprising:
a receiver (13) having a receiver housing (16), wherein said receiver housing (16) comprises a plurality of receiver housing electrical contacts (18), and an insulator assembly (28) holding and electrically insulating each one of said plurality of receiver housing electrical contacts (18) from each other, wherein said receiver housing (16) is configured to physically couple to a rigid assembly (12); and
a connector (14) comprising a connector housing (20) with an interlock mechanism cap (36), a device enclosure (34) and a compression grommet (30) inside said connector device (14), wherein the interlock mechanism cap (36) is suitable for engaging with the receiver (13), wherein said interlocking mechanism cap (36) provides assurance that the connector (14) and receiver (13) do not disengage during operation, wherein said device enclosure (34) receives said compression grommet (30) and a terminal end (21) of a flexible assembly (22) and a flexible assembly retention component (40) which securely retains the terminal end of the flexible assembly (22) within the connector (14), wherein said compression grommet (30) is located between said terminal end of the flexible assembly (22) and a top wall of said device enclosure (34), said terminal end (21) of the flexible assembly (22) comprising a plurality of flexible assembly electrical contacts (24),
wherein said connector (14) is configured such that each one of said plurality of receiver housing electrical contacts (18) is mated inside said receiver housing (16) by a solderless connection method to a corresponding one of a plurality of flexible assembly electrical contacts (24).

2. The electrical assembly combination (10) of claim 1, wherein said solderless connection comprises a compressive contact system.

3. The electrical assembly combination (10) of claim 1, wherein said solderless connection comprises a spring probe system.

4. The electrical assembly combination (10) of claim 1, wherein said solderless connection comprises a pin-socket mating system.

5. The electrical assembly combination (10) of claim 1, wherein said connector housing (20) further comprises a device enclosure (34), wherein said device enclosure (34) and the interlock mechanism cap (36) enclose said terminal end of said flexible assembly (22) inside said connector (14).

6. The electrical assembly combination (10) of claim 1, wherein said receiver (13) further comprises a sealing component (29) for sealing the receiver housing (16) to the connector (14).

7. The electrical assembly combination (10) of claim 6, wherein said sealing component (29) is configured to serve one or more functions selected from the group comprising environmental sealing, EMI/EMC protection, prevention of foreign object contamination and vibration dampening.

## Patentansprüche

1. Kombination (10) elektrischer Anordnungen, die Folgendes umfasst:
eine Aufnahme (13) mit einem Aufnahmegehäuse (16), wobei das Aufnahmegehäuse (16) eine Vielzahl von elektrischen Kontakten (18) des Aufnahmegehäuses und eine Isolatoranordnung (28), die jeden der Vielzahl von elektrischen Kontakten (18) des Aufnahmegehäuses hält und elektrisch voneinander isoliert, umfasst, wobei das Aufnahmegehäuse (16) dazu konfiguriert ist, physisch an eine starre Anordnung (12) gekoppelt zu werden; und
einen Verbinder (14), umfassend ein Verbindergehäuse (20) mit einer Verriegelungsmechanismuskappe (36), einer Vorrichtungsumhüllung (34) und einer Drucktülle (30) innerhalb der Verbindervorrichtung (14), wobei die Verriegelungsmechanismuskappe (36) geeignet ist, um mit der Aufnahme (13) in Eingriff zu treten, wobei die Verriegelungsmechanismuskappe (36) gewährleistet, dass sich der Verbinder (14) und die Aufnahme (13) während des Betriebs nicht voneinander lösen, wobei die Vorrichtungsumhüllung (34) die Drucktülle (30) und ein Anschlussende (21) einer flexiblen Anordnung (22) und eine Haltekomponente (40) für die flexible Anordnung, die das Anschlussende der flexiblen Anordnung (22) sicher innerhalb des Verbinders (14) hält, aufnimmt, wobei sich die Drucktülle (30) zwischen dem Anschlussende der flexiblen Anordnung (22) und einer oberen Wand der Vorrichtungsumhüllung (34) befindet, wobei das Anschlussende (21) der flexiblen Anordnung (22) eine Vielzahl von elektrischen Kontakten (24) der flexiblen Anordnung umfasst,
wobei der Verbinder (14) derart konfiguriert ist, dass jeder der Vielzahl von elektrischen Kontakten (18) des Aufnahmegehäuses innerhalb des Aufnahmegehäuses (16) durch ein lotfreies Verbindungsverfahren mit einem entsprechenden einer Vielzahl elektrischer Kontakte (24) der flexiblen Anordnung gepaart ist.

2. Kombination (10) elektrischer Anordnungen nach Anspruch 1, wobei die lotfreie Verbindung ein Druckkontaktsystem umfasst.

3. Kombination (10) elektrischer Anordnungen nach Anspruch 1, wobei die lotfreie Verbindung ein Federkontaktstiftsystem umfasst.

4. Kombination (10) elektrischer Anordnungen nach Anspruch 1, wobei die lotfreie Verbindung ein Stift-Buchsen-Paarungssystem umfasst.

5. Kombination (10) elektrischer Anordnungen nach Anspruch 1, wobei das Verbindergehäuse (20) weiter eine Vorrichtungsumhüllung (34) umfasst, wobei die Vorrichtungsumhüllung (34) und die Verriegelungsmechanismuskappe (36) das Anschlussende der flexiblen Anordnung (22) innerhalb des Verbinders (14) umhüllen.

6. Kombination (10) elektrischer Anordnungen nach Anspruch 1, wobei die Aufnahme (13) weiter eine Dichtungskomponente (29) zum Dichten des Aufnahmegehäuse (16) an dem Verbinder (14) umfasst.

7. Kombination (10) elektrischer Anordnungen nach Anspruch 6, wobei die Dichtungskomponente (29) dazu konfiguriert ist, eine oder mehrere Funktionen zu erfüllen, die aus der Abdichtung der Umgebung, EMI-/EMV-Schutz, Verhinderung der Verunreinigung durch Fremdkörper und Schwingungsdämpfung umfassenden Gruppe ausgewählt werden.

## Revendications

1. Combinaison d'ensembles électriques (10) comportant :
un récepteur (13) ayant un boîtier de récepteur (16), dans laquelle ledit boîtier de récepteur (16) comporte une pluralité de contacts électriques de boîtier de récepteur (18), et un ensemble isolateur (28) retenant et isolant électriquement chaque contact de ladite pluralité de contacts électriques de boîtier de récepteur (18) les uns par rapport aux autres, dans laquelle ledit boîtier de récepteur (16) est configuré à des fins d'accouplement physique à un ensemble rigide (12) ; et
un connecteur (14) comportant un boîtier de connecteur (20) avec un couvercle à mécanisme d'interverrouillage (36), une enveloppe de dispositif (34) et une rondelle de compression (30) à l'intérieur dudit dispositif connecteur (14), dans laquelle le couvercle à mécanisme d'interverrouillage (36) convient à des fins de mise en prise avec le récepteur (13), dans laquelle ledit couvercle à mécanisme d'interverrouillage (36) offre l'assurance que le connecteur (14) et le récepteur (13) ne se séparent pas lors du fonctionnement, dans laquelle ladite enveloppe de dispositif (34) reçoit ladite rondelle de compression (30) et une extrémité formant borne (21) d'un ensemble flexible (22) et un composant de retenue d'ensemble flexible (40) qui retient de manière sûre l'extrémité formant borne de l'ensemble flexible (22) à l'intérieur du connecteur (14), dans laquelle ladite rondelle de compression (30) est située entre ladite extrémité formant borne de l'ensemble flexible (22) et une paroi supérieure de ladite enveloppe de dispositif (34), ladite extrémité formant borne (21) de l'ensemble flexible (22) comportant une pluralité de contacts électriques d'ensemble flexible (24),
dans laquelle ledit connecteur (14) est configuré de telle sorte que chaque contact de ladite pluralité de contacts électriques de boîtier de récepteur (18) est accouplé à l'intérieur dudit boîtier de récepteur (16) par un procédé de connexion sans soudure à un contact correspondant d'une pluralité de contacts électriques d'ensemble flexible (24).

2. Combinaison d'ensembles électriques (10) selon la revendication 1, dans laquelle ladite connexion sans soudure comporte un système de contact par compression.

3. Combinaison d'ensembles électriques (10) selon la revendication 1, dans laquelle ladite connexion sans soudure comporte un système de sonde à ressort.

4. Combinaison d'ensembles électriques (10) selon la revendication 1, dans laquelle ladite connexion sans soudure comporte un système d'accouplement à douille et broche.

5. Combinaison d'ensembles électriques (10) selon la revendication 1, dans laquelle ledit boîtier de connecteur (20) comporte par ailleurs une enveloppe de dispositif (34), dans laquelle ladite enveloppe de dispositif (34) et le couvercle à mécanisme d'interverrouillage (36) renferment ladite extrémité formant borne dudit ensemble flexible (22) à l'intérieur dudit connecteur (14).

6. Combinaison d'ensembles électriques (10) selon la revendication 1, dans laquelle ledit récepteur (13) comporte par ailleurs un composant de scellage (29) servant à sceller le boîtier de récepteur (16) sur le connecteur (14).

7. Combinaison d'ensembles électriques (10) selon la revendication 6, dans laquelle ledit composant de scellage (29) est configuré pour mettre en oeuvre une ou plusieurs fonctions sélectionnées dans le groupe constitué par la protection étanche contre l'environnement, la protection EMI/EMC, la prévention de contamination par des corps étrangers et l'amortissement de vibrations.
